# EUROPÄISCHE PATENTANMELDUNG

(11) **EP 2 058 840 A2**
(43) Veröffentlichungstag der Anmeldung: **13.05.2009**
(21) Anmeldenummer: 08167939.1
(22) Anmeldetag: 30.10.2008
(51) Int. Cl.: H01L 21/00

(54) **Aufheizblöcke**

(30) Priorität: 07.11.2007 DE 102007054527
(71) Anmelder: Deutsches Zentrum für Luft- und Raumfahrt e.V., 51147 Köln (DE)
(72) Erfinder: Dr. Hald, Hermann, 71287, Weissach (DE); Dr. Funk, Klaus, 85521, Ottobrunn (DE); Heidenreich, Bernhard, 71679, Asperg (DE)
(74) Vertreter: Hoeger, Stellrecht & Partner Patentanwälte

(57) **Zusammenfassung**

Um bei einem Aufheizblock für eine Anlage zur thermischen Behandlung eines Substrats, insbesondere eines Halbleitersubstrats, wobei die Anlage einen Substrataufnahmeraum und auf mindestens einer Seite des Substrataufnahmeraums den Aufheizblock aufweist, mit welchem das Substrat mechanisch berührungslos thermisch behandelbar ist, einerseits eine hohe mechanische Langzeitstabilität zu erhalten und andererseits die Möglichkeit zu haben, einen Gasstrom, insbesondere einen Gasstrom aus reaktivem Prozessgas, durch den Aufheizblock hindurchzuführen, wird vorgeschlagen, dass der Aufheizblock als Faserverbundkörper ausgebildet ist, dass der Faserverbundkörper mit Durchlässen für einen diesen von einer Flachseite zur anderen Flachseite durchsetzenden Gasstrom ausgebildet ist.

## Beschreibung

Die Erfindung betrifft einen Aufheizblock für eine Anlage zur thermischen Behandlung eines Substrates, insbesondere eines Halbleitersubstrats.

Die bekannte thermische Behandlung von Substraten erfolgt insbesondere zu dem Zweck, in den Substraten jegliche Arten von Prozessen durchzuführen, insbesondere bei Halbleitersubstraten dazu, in den Halbleitersubstraten, beispielsweise Halbleiterwafern thermisch aktivierbare Prozesse stattfinden zu lassen.

Derartige Anlagen zur thermischen Behandlung von Substraten sind beispielsweise Anlagen zur schnellen thermischen Behandlung von Substraten, wobei Wärmebehandlungen mit Temperaturänderungen von mehr als 50K/sek, vorzugsweise Temperaturänderungen im Bereich von 100K/sek bis hin zu 1000K/sek realisiert werden, und wobei Maximaltemperaturen von ungefähr 300°C bis ungefähr 1300°C für eine Zeitdauer im Bereich von ungefähr 1 bis ungefähr 10 sek erreicht werden.

Derartige schnelle Wärmebehandlungen finden beispielsweise Anwendung bei der Herstellung von Halbleiterbauelementen und dienen beispielsweise zur Durchführung folgender Prozesse: elektrische Aktivierung von Dotierelementen, Defektausheilung, Diffusion von chemischen Elementen, Oxidation von chemischen Elementen, Nitridierung, Silizidierung, Erzeugung von High-K Anneals, Durchführung von Epidaxie, Durchführung von Chemical Vapor Deposition, Materialverdichtung, Trocknungsvorgänge zur thermischen Entoxidierung sowie zur thermochemischen Oxidierung.

Bei derartigen Anlagen zur thermischen Behandlung von Substraten, insbesondere Halbleitersubstraten ist ein Substrataufnahmeraum und mindestens auf einer Seite des Substrataufnahmeraums ein Aufheizblock vorgesehen, mit welchem das Substrat im Substrataufnahmeraum berührungslos thermisch und gegebenenfalls mit Prozessgas behandelbar ist.

Bei einem derartigen Aufheizblock besteht das Problem, einerseits eine hohe mechanische Langzeitstabilität zu erhalten und andererseits die Möglichkeit zu haben, einen Gasstrom, insbesondere einen Gasstrom aus reaktivem Prozessgas, durch den Aufheizblock hindurchzuführen.

Diese Aufgabe wird bei einem Aufheizblock der eingangs beschriebenen Art erfindungsgemäß dadurch gelöst, dass der Aufheizblock als Faserverbundkörper ausgebildet ist, dass der Faserverbundkörper mit Durchlässen für einen diesen von einer Flachseite zur anderen Flachseite durchsetzenden Gasstrom ausgebildet ist.

Der Vorteil der erfindungsgemäßen Lösung ist einerseits darin zu sehen, dass mit dieser ein mechanisch langzeitstabiler Aufheizblock zur Verfügung steht der außerdem aufgrund der Durchströmung mit Gas verbesserte Temperaturausgleichseigenschaften aufweist.

Eine günstige Lösung sieht vor, dass der Faserverbundkörper im Bereich seiner wesentlichen, an dem Gasstrom angrenzenden Oberflächen ein mit dem Gasstrom reaktionsunfähiges Material aufweist, so dass der Aufheizblock in der Lage ist, den Gasstrom mit Prozessgas, insbesondere reaktives Prozessgas, optimal zu führen.

Besonders günstig ist es dabei, wenn der Faserverbundkörper im Bereich der an den Gasstrom angrenzenden Oberflächen Keramikmaterial aufweist, da Keramikmaterial die Eigenschaft hat, gegen eine Vielzahl von reaktionsfähigen Prozessgasen reaktionsunfähig zu sein und somit die Prozessgase keinerlei Zerstörung im Bereich der an den Gasstrom angrenzenden Oberflächen entfachen können.

Prinzipiell könnte dabei der gesamte Faserverbundkörper aus Keramikmaterial sein, so dass zwangsläufig auch die an den Gasstrom angrenzenden Oberflächen aus Keramikmaterial sind. Ein derartiger Faserverbundkörper kann gebildet sein aus Fasern und Matrixmaterial, die beide aus einem keramischen Material sind.

Da Keramik jedoch ein sehr sprödes Material ist und eine nennenswerte thermische Ausdehnung aufweist, ist vorzugsweise vorgesehen, dass die an den Gasstrom angrenzenden Oberflächen die Oberflächen von Keramikschichten des Faserverbundkörpers sind, so dass die Möglichkeit besteht, unterhalb der Keramikschichten den Faserverbundkörper aus einem Material auszubilden, das weniger spröde ist, so dass die mechanische Langzeitstabilität des Aufheizblocks verbessert werden kann.

Hinsichtlich der Dicke der Keramikschichten wurden bislang keine näheren Angaben gemacht.

So sieht eine vorteilhafte Lösung vor, dass die Keramikschichten eine Dicke von mindestens ungefähr 1 µm, noch besser mindestens ungefähr 2 µm, aufweisen.

Ferner ist es günstig, um die Keramikschichten nicht zu dick auszuführen, wenn die Keramikschichten eine Dicke von maximal ungefähr 50 µm aufweisen, so dass die Tendenz der Keramikschichten zu Rissbildungen begrenzt oder reduziert ist.

Besonders günstig ist es hierbei, wenn die von den Durchlässen gebildeten Durchlassquerschnitte zwischen einem Zentralbereich des Aufheizblocks und Außenbereichen des Aufheizblocks variieren, so dass damit die Möglichkeit besteht, die diffuse Gasströmung, die im Bereich des Substrats auftritt, an optimale Strömungsverhältnisse anzupassen, insbesondere so anzupassen, dass sich im Bereich des Substrats optimale Strömungs- und Konzentrationsverhältnisse von Prozessgas ergeben.

Eine vorteilhafte Lösung sieht dabei vor, dass die Durchlässe in Außenbereichen des Aufheizblocks einen kleineren Durchlassquerschnitt aufweisen als die Durchlässe im Zentralbereich des Aufheizblocks.

Hinsichtlich der Ausbildung der Durchlässe wurden bislang keine näheren Angaben gemacht.

So sieht eine vorteilhafte Lösung vor, dass die Durchlässe durch definiert eingebrachte Kanäle oder Bohrungen in dem Faserverbundkörper realisiert sind.

Um jedoch im Bereich des Substrats eine möglichst diffuse Gasströmung zu erhalten hat es sich als vorteilhaft erwiesen, wenn die Durchlässe durch Poren und/oder Risse des Faserverbundkörpers gebildet sind. Damit lassen sich viele einen sehr kleinen Gasführungsquerschnitt aufweisende Durchlässe in dem Aufheizblock realisieren, die wiederum auf Seiten des Substrats zu einer diffusen Gasströmung führen, die den Vorteil hat, dass sie sehr gleichmäßig ist und somit zu keinen großen Strömungsgradienten an der Oberfläche des Substrats führt.

Ferner wurden im Hinblick auf die Ausbildung des Faserverbundkörpers selbst keine näheren Angaben gemacht.

Grundsätzlich könnten die Fasern in dem Faserverbundkörper statistisch verteilt angeordnet werden, wobei immer noch die Möglichkeit besteht, den Faserverbundkörper derart porös auszuführen, dass ein ausreichender Durchlassquerschnitt für den Gasstrom durch die Poren und gegebenenfalls entstehenden Risse in einem derartigen Faserverbundkörper zur Verfügung steht.

Eine besonders günstige Lösung sieht jedoch vor, dass die Fasern in dem Faserverbundkörper näherungsweise längs einer Vorzugsrichtung verlaufen.

Das Vorsehen einer derartigen Vorzugsrichtung hat den Vorteil, dass damit auch ein Verlauf der Risse im Faserverbundkörper zumindest näherungsweise vorgegeben werden kann, da in einem derartigen Fall die Risse näherungsweise ebenfalls längs der Vorzugsrichtung verlaufen.

Besonders günstig ist es, um eine optimale Gasströmung von einer Flachseite zur anderen Flachseite zu erhalten, wenn die Vorzugsrichtung quer zu den Flachseiten des Aufheizblocks verläuft, so dass damit die Möglichkeit besteht, den Gasstrom von einer Flachseite des Aufheizblocks zur anderen Flachseite des Aufheizblocks zu führen, da die bei einer derartigen Vorzugsrichtung entstehenden Risse ebenfalls von einer Flachseite zur anderen verlaufen und somit Durchlässe für den Gasstrom zur Verfügung stellen.

Hinsichtlich der Ausbildung des Keramikmaterials selbst wurden bislang noch keine näheren Angaben gemacht.

Als Keramiken kommen zweckmäßigerweise oxidische und/oder nichtoxidische Keramiken zum Einsatz.

So könnte beispielsweise als Keramikmaterial Siliziumnitrid oder Aluminiumnitrid oder Aluminiumoxid eingesetzt werden.

Ein anderes besonders vorteilhaftes Keramikmaterial ist Siliziumcarbid.

Ferner wurden auch hinsichtlich der Fasern des Faserverbundkörpers keine näheren Angaben gemacht. So besteht die Möglichkeit, die Fasern des Faserverbundkörpers selbst als Keramikfasern auszubilden.

In diesem Fall ist zweckmäßigerweise dann auch vorgesehen, dass das Matrixmaterial ein Keramikmaterial ist.

Um jedoch eine gute mechanische Langzeitstabilität des Aufheizblocks zu erreichen hat es sich als besonders vorteilhaft erwiesen, wenn der Faserverbundkörper Kohlenstofffasern umfasst.

Für den Fall, dass der Faserverbundkörper Kohlenstofffasern umfasst, hat es sich ebenfalls als vorteilhaft erwiesen, wenn der Faserverbundkörper Kohlenstoff als Matrixmaterial umfasst, da damit sowohl hinsichtlich der Fasern als auch des Matrixmaterials ein Material zur Verfügung steht, dass hinsichtlich seiner Duktilität weit vorteilhafter ist als Keramikmaterial und somit keinerlei Probleme hinsichtlich der Sprödigkeit des Materials und somit der unerwarteten Rissbildung schafft.

Insbesondere im Fall, dass die Kohlenstofffasern und das Matrixmaterial aus Kohlenstoff sind, hat es sich als vorteilhaft erwiesen, wenn der Kohlenstoff an den an den Gasstrom angrenzenden Oberflächen zu Siliziumcarbid umgewandelt ist. Eine derartige Schicht aus Siliziumcarbid bildet somit eine Schutzschicht gegen Reaktionen mit dem im Gasstrom geführten Prozessgas.

Da ein derartiger Aufheizblock üblicherweise zum Einsatz kommt, wenn allein aufgrund dessen thermischer Masse eine rasche Aufheizung des Substrats erfolgen kann, ohne dass sich die Temperatur des Aufheizblocks nennenswert ändert, ist vorzugsweise vorgesehen, dass der Aufheizblock eine thermische Masse aufweist, die ein 5-faches, noch besser ein 10-faches, und günstigerweise ein 100-faches der thermischen Masse des Substrats beträgt.

Darüber hinaus betrifft die Erfindung eine Anlage zur thermischen Behandlung von Substraten, insbesondere Halbleitersubstraten, umfassend einen Substrataufnahmeraum und auf mindestens einer Seite des Substrataufnahmeraums einen Aufheizblock, mit welchem das Substrat im Substrataufnahmeraum thermisch behandelbar ist.

Bei einer derartigen Anlage ist erfindungsgemäß vorgesehen, dass der Aufheizblock entsprechend einem oder mehreren der voranstehend dargestellten erfindungsgemäßen Merkmale ausgebildet ist.

Ein derartiger Aufheizblock erlaubt es, bei einer Anlage der vorstehend beschriebenen Art eine ausreichende mechanische Langzeitstandfestigkeit und Betriebssicherheit zu erreichen.

Ein derartiger Aufheizblock ist dabei in unterschiedlichster Art und Weise aufheizbar.

Eine vorteilhafte Lösung sieht vor, dass der Aufheizblock durch eine Heizeinrichtung mechanisch berührungslos aufheizbar ist.

Eine derartige mechanisch berührungslos arbeitende Heizeinrichtung kann beispielsweise dadurch realisiert sein, dass die Heizeinrichtung Heizlampen umfasst, welche durch Wärmestrahlung den Aufheizblock aufheizen, wobei entweder eine direkte Aufheizung des Aufheizblocks erfolgen kann, oder eine indirekte, nämlich durch Aufheizung eines den Aufheizblock tragenden Gehäuseteils.

Eine Lösung sieht vor, dass die Heizeinrichtung Heizstrahler umfasst.

Eine andere vorteilhafte Lösung sieht vor, dass die Heizeinrichtung einen Induktor umfasst, der in dem Aufheizblock Wirbelströme umfasst, die zu einer Aufheizung des Aufheizblocks führen.

Eine weitere vorteilhafte Lösung sieht vor, dass die Heizeinrichtung einen Mikrowellengenerator umfasst, der über Mikrowellen die Heizenergie in den Aufheizblock einkoppelt.

Schließlich sieht eine weitere Möglichkeit vor, dass der Aufheizblock durch körperlichen thermischen Kontakt mit der Heizeinrichtung aufheizbar ist.

Eine derartige Lösung sieht beispielsweise vor, dass der Aufheizblock in direktem oder indirektem körperlichen Kontakt mit einer Widerstandsheizung steht, so dass die Aufheizung des Aufheizblocks über körperliche Wärmeleitung erfolgt.

Weitere Merkmale und Vorteile der Erfindung sind Gegenstand der nachfolgenden Beschreibung sowie der zeichnerischen Darstellung einiger Ausführungsbeispiele.

In der Zeichnung zeigen:
- Fig. 1: einen schematischen teilweisen Schnitt durch eine Anlage zur thermischen Behandlung eines Substrats gemäß einem ersten Ausführungsbeispiel;
- Fig. 2: einen vergrößerten Schnitt durch den Aufheizblock gemäß dem ersten Ausführungsbeispiel;
- Fig. 3: eine nochmals vergrößerte Schnittdarstellung von Poren und/oder Rissen in dem Aufheizblock gemäß Fig. 2;
- Fig. 4: einen Schnitt ähnlich Fig. 2 durch einen Aufheizblock gemäß einem zweiten Ausführungsbeispiel;
- Fig. 5: einen Schnitt ähnlich Fig. 1 durch eine Anlage gemäß einem dritten Ausführungsbeispiel
- Fig. 6: einen Schnitt ähnlich Fig. 1 durch eine Anlage gemäß einem vierten Ausführungsbeispiel und
- Fig. 7: einen Schnitt ähnlich Fig. 1 durch eine Anlage gemäß einem fünften Ausführungsbeispiel.

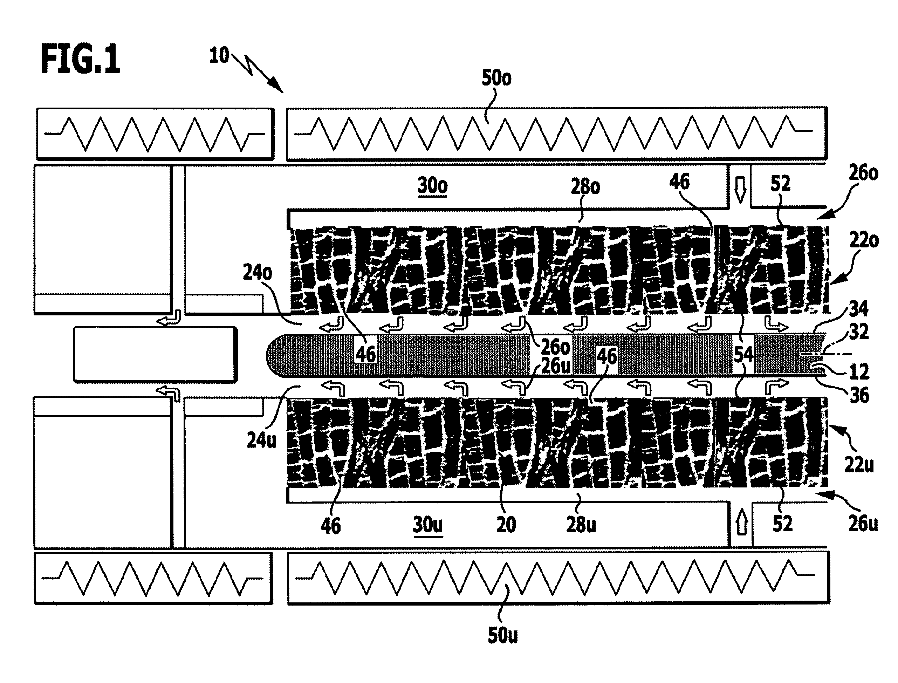

Ein in Fig. 1 dargstelltes erstes Ausführungsbeispiel einer erfindungsgemäßen Anlage 10 zur thermischen Behandlung eines Substrats 12, welches sich parallel zu einer Fläche 32 erstreckt, umfasst einen Substrataufnahmeraum 20, welcher zwischen zwei sich ebenfalls parallel zur Fläche 32 erstreckenden Aufheizblöcken 22, nämlich einem oberen Aufheizblock 22o und einem unteren Aufheizblock 22u, liegt, wobei in dem Substrataufnahmeraum 20 das Substrat 12 relativ zu den Aufheizblöcken 22o und 22u mittels jeweils eines Gaspolsters 24o bzw. 24u geführt ist, so dass das Substrat 12 mechanisch berührungslos zwischen den Aufheizblöcken 22o und 22u während der thermischen Behandlung liegt.

Die Gaspolster 24o und 24u werden dabei erzeugt durch einen die Aufheizblöcke 22o und 22u jeweils in einer Richtung quer zur Fläche 32 durchsetzenden Gasstrom 26o bzw. 26u von Prozessgas, welcher von außen in einen jeweils auf einer dem Substrat 12 gegenüberliegenden Seite der Aufheizblöcke 22o und 22u angeordneten Verteilraum 28o bzw. 28u zwischen dem jeweiligen Aufheizblock 22o bzw. 22u und einem den jeweiligen Aufheizblock 22o bzw. 22u Gehäuseteil 30o bzw. 30u eintritt und in dem Verteilraum 28o bzw. 28u sich über die Ausdehnung des jeweiligen Aufheizblocks 22o bzw. 22u in einer Richtung parallel zu der Fläche 32 ausbreitet.

Der Verteilraum 28o bzw. 28u erstreckt sich dabei ebenfalls über die gesamte Erstreckung des jeweiligen Aufheizblocks 22o bzw. 22u parallel zur Fläche 32, so dass die Möglichkeit besteht, die Aufheizblöcke 22o und 22u im Bereich ihrer gesamten parallel zur Fläche 32 verlaufenden Ausdehnung mit Gas zu durchströmen, welches jeweils nach seinem Weg von dem Verteilraum 28o bzw. 28u zum Substrataufnahmeraum 20 in dem Substrataufnahmeraum 20 einen zur Erzeugung des jeweiligen Gaspolsters 24o bzw. 24u diffusen Gasstrom 26 ergibt, so dass das Substrat 12 über seine ganze Ausdehnung in Richtung der Fläche 32 sowohl mit einer Oberseite 34 als auch mit einer Unterseite 36 an ein sich in Richtung parallel zur Fläche 32 gleichförmig ausgebildetes Gaspolster 24o bzw. 24u angrenzt und durch dieses geführt ist.

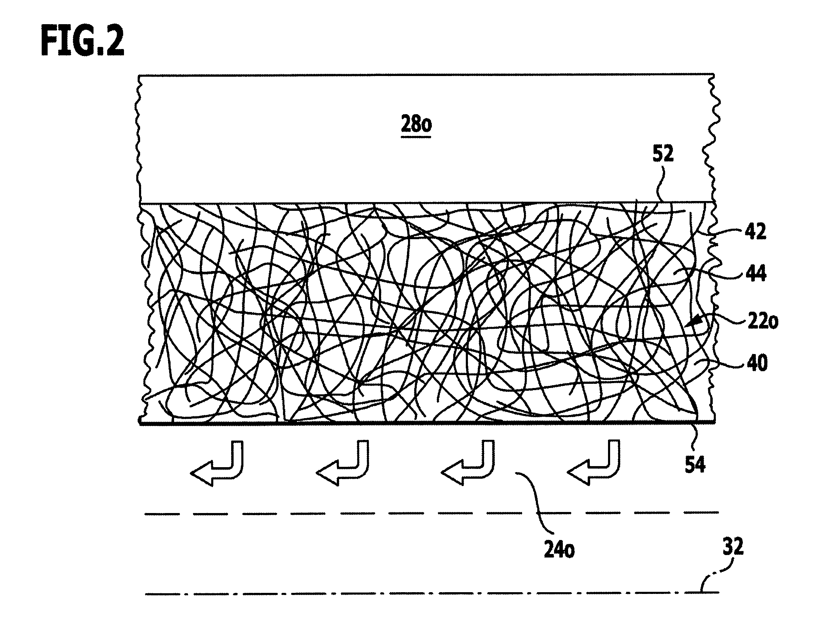

Um ein derartiges, parallel zur Fläche 32 im Wesentlichen gleichmäßiges Gaspolster 24 zu erzeugen ist, wie in Fig. 2 dargestellt, der jeweilige Aufheizblock 22, in diesem Fall der Aufheizblock 22o, als Faserverbundkörper 40 ausgebildet, in welchem einerseits Fasern 42 sowie zwischen den Fasern Matrixmaterial 44 vorhanden sind, das die Fasern 42 miteinander verbindet.

In der Matrix 44 sind Poren oder Risse 46 vorhanden, die dadurch entstehen, dass die Matrix 44 die Zwischenräume zwischen den Fasern 42 nicht vollständig ausfüllt, sondern Freiräume verbleiben.

Diese Poren und Risse 46 erstrecken sich dabei durch den gesamten Aufheizblock 22 hindurch, so dass das Gas durch diese Poren und Risse 46 hindurchtreten und den jeweiligen Aufheizblock 22 von seiner dem Verteilraum 28 zugewandten Flachseite 52 zu seiner dem Substrat 12 zugewandten Flachseite 54 durchströmen kann.

Das prozentuale Volumen der offenen Poren und Risse 46 des Faserverbundkörpers 40 liegt beispielsweise zwischen ungefähr 1% und ungefähr 20%.

Bei einem vorteilhaften Ausführungsbeispiel wird der Faserverbundkörper 40 dadurch hergestellt, dass Kohlenstofffasern 42 und Harz miteinander vermischt und in eine dem Aufheizblock 22 entsprechende Form gebracht werden.

Durch Pyrolyse des Harzes entsteht ein Körper aus den Kohlenstofffasern 42 und der Matrix 44 aus Kohlenstoff zwischen den Kohlenstofffasern 42, der die Risse und Poren 46 aufweist.

Aufgrund der Risse und Poren 46 ist ein derart aufgebauter Aufheizblock 22 prinzipiell zur Erzeugung des jeweiligen diffusen Gasstroms 26 unter Bildung des Gaspolsters 24 geeignet.

Sollte jedoch das Gaspolster 24 ein reaktives, beispielsweise Sauerstoff oder andere reaktive chemische Elemente enthaltendes Gas sein, würde ein Aufheizblock 22 mit dem Gas zugänglichen freiliegendem Kohlenstoff, sei es Kohlenstoff der Kohlenstofffasern 42 oder der Matrix 44, mit dem Gas reagieren.

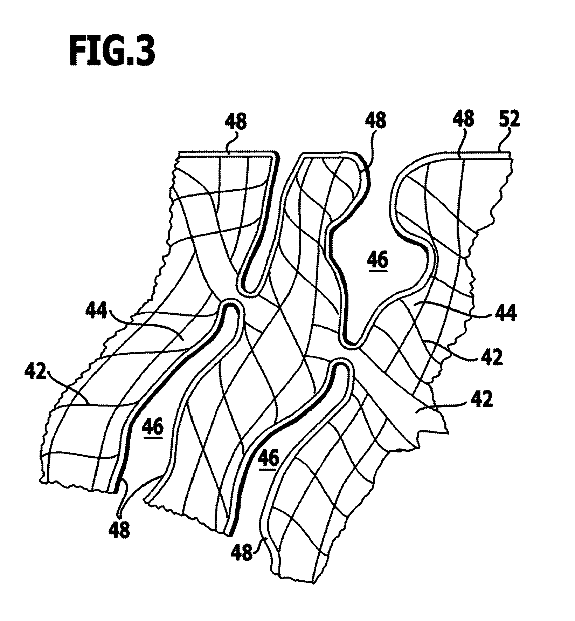

Aus diesem Grund ist, wie in Fig. 3 dargestellt, vorgesehen, dass alle freien Oberflächen sowohl des Faserverbundkörpers 40 selbst, insbesondere der der Flachseiten 52 und 54, als auch der Poren und Risse 46 zumindest insoweit, als diese dem Gas ausgesetzt werden können, mindestens mit einer Schicht 48 aus Siliziumcarbid überzogen sind, die beispielsweise dadurch erhältlich ist, dass nach der Pyrolyse des Körpers aus Kohlenstofffasern 42 und Matrix 44 aus Kohlenstoff eine Silizierung erfolgt, die dazu führt, dass das Silizium jeweils an den für diese zugänglichen Oberflächen mit dem Kohlenstoff zu Siliziumcarbid reagiert und damit alle für das Silizium und somit auch für das später durchzuführende Gas zugänglichen Oberflächen des Aufheizblocks 22, insbesondere auch im Bereich der Poren und Risse 46, mit der Schutzschicht 48 aus Siliziumcarbid versieht.

Eine derartige Silizierung zur Ausbildung der Schutzschicht 48 lässt sich vorzugsweise dadurch durchführen, dass eine Flüssigsilizierung erfolgt und nachfolgend ein Entfernen des Siliziums erfolgt, das nicht zu der Schutzschicht 48 reagiert hat, und somit zumindest teilweise die Risse oder Poren 46 verschließen würde.

Eine andere Möglichkeit der Silizierung ist eine Silizierung mittels CVD, das heißt Chemical Vapor Deposition, oder mittels CVI, das Heißt Chemical Vapor Infiltration, bei welchen alle einem Gas zugänglichen Poren und Risse 46 erreicht werden , und welche somit eine Möglichkeit darstellen, in allen später auch für das Gas zugänglichen Rissen und Poren 46 die Schutzschicht 48 zu erzeugen.

Bei der Silizierung des jeweiligen Aufheizblocks 22 ist es dabei nicht notwendig, den gesamten Kohlenstoff der Fasern 42 und der Matrix 44 in Siliziumcarbid umzuwandeln, da dadurch die mechanischen Eigenschaften des jeweiligen Aufheizblocks 22 beeinflusst würden, denn die mechanisch/thermische Schadenstoleranz der Kohlenstofffasern 42 und des Teils der Matrix 44 aus Kohlenstoff wirkt sich bei den erfindungsgemäßen Aufheizblöcken 22 vorteilhaft auf die Langzeitstabilität und auch die Temperaturwechselfestigkeit des Aufheizblocks 22 aus.

Bei der erfindungsgemäßen Anlage werden die Aufheizblöcke 22 auf eine konstante Temperatur, beispielsweise eine Temperatur von ungefähr 1200°C, aufgeheizt und auf dieser Temperatur geregelt gehalten.

Die Aufheizblöcke 22 haben dabei eine derart große thermische Masse oder Wärmespeicherkapazität, dass diese ihre Temperatur bei Einführen des Substrats 12 in den Substrataufnahmeraum 20 nicht merklich ändern, sondern einfach aufgrund ihrer eigenen Wärmespeicherkapazität das Substrat 12 mit aufheizen, wobei die Aufheizung des Substrats 12 über eine mechanisch berührungslose Wärmeleitung durch Wärmeleitung in den Gaspolstern 24 seitens des Gases erfolgt, so dass das Substrat 12 durch die Wärmeleitung in den Gaspolstern 24 thermisch gut an die Aufheizblöcke 22 angekoppelt ist.

Aus diesem Grund haben die Gaspolster 24 vorzugsweise eine Dicke von weniger als 300 µm, noch besser weniger als 200 µm, um eine effiziente Wärmeleitung zwischen den Aufheizblöcken 22 und dem Substrat 12 zu gewährleisten.

Aufgrund der großen Masse der Aufheizblöcke 22 besteht somit nicht die Notwendigkeit, die Aufheizblöcke 22 schnell aufzuheizen und abzukühlen, vielmehr werden die Aufheizblöcke 22 lediglich auf einer konstanten Temperatur gehalten, so dass lediglich die Wärmeverluste durch Nachheizen der Aufheizblöcke 22 ausgeglichen werden müssen. Ein derartiges Nachheizen der Aufheizblöcke 22 erfolgt beispielsweise über Heizeinrichtungen 50o und 50u. Die Heizeinrichtungen 50 können beispielsweise Lampen umfassen, die durch Strahlung die jeweiligen Gehäuseteile 30o und 30u und somit über diese mit körperlichem Wärmekontakt die Aufheizblöcke 22o bzw. 22u aufheizen oder elektrische Widerstandsheizelemente, die auf den jeweiligen Gehäuseteilen 30o bzw. 30u aufliegen und über die Gehäuseteile in körperlichem Wärmekontakt mit den Aufheizblöcken 22o und 22u stehen.

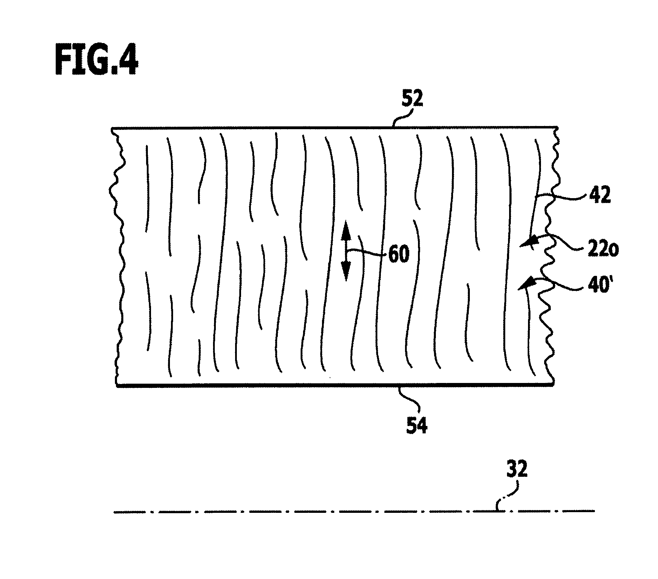

Im Gegensatz zum ersten Ausführungsbeispiel, bei welchem, wie in Fig. 2 dargestellt, die Fasern 42 in der Art eines Vlieses ohne Vorzugsrichtung in dem Faserverbundkörper 40 verlaufen, ist bei einem zweiten, in Fig. 4 dargestellten Ausführungsbeispiel vorgesehen, dass die Fasern 42 in dem Faserverbundkörper 40' sich im Wesentlichen entlang einer Vorzugsrichtung 60 erstrecken, die quer, vorzugsweise senkrecht zu der Fläche 32 und somit quer, vorzugsweise senkrecht zu den dem Verteilraum 28 zugewandten und dem Substrat 12 zugewanden Seiten 52 bzw. 54 der Aufheizkörper 22 verläuft.

Bei einer derartigen Vorzugsrichtung der Fasern 42 erfolgt eine bevorzugte Ausbildung der Risse und Poren 46 entlang den Fasern 42 und somit in der Vorzugsrichtung 60, so dass damit die Möglichkeit besteht, aufgrund der die Aufheizblöcke 42 entlang der Vorzugsrichtung 60 der Fasern durchsetzenden Risse 46 den Strömungsquerschnitt für das die Aufheizblöcke 22 von dem Verteilraum 28 zum Substrataufnahmeraum 20 strömende Gas zu vergrößern und somit einen ausreichend großen Gasstrom zur Aufrechterhaltung des Gaspolsters 24 im Substrataufnahmeraum 20 zu erzeugen.

Da die sich längs der Vorzugsrichtung 60 der Fasern 42 durch die Aufheizkörper 22 erstreckenden Risse statistisch über die gesamte Ausdehnung der Aufheizkörper 22 in Richtung der Fläche 32 verteilt sind, wird eine optimale, näherungsweise homogene, diffuse Gasverteilung zur Ausbildung der Gaspolster 24 im Substrataufnahmeraum 20 erreicht.

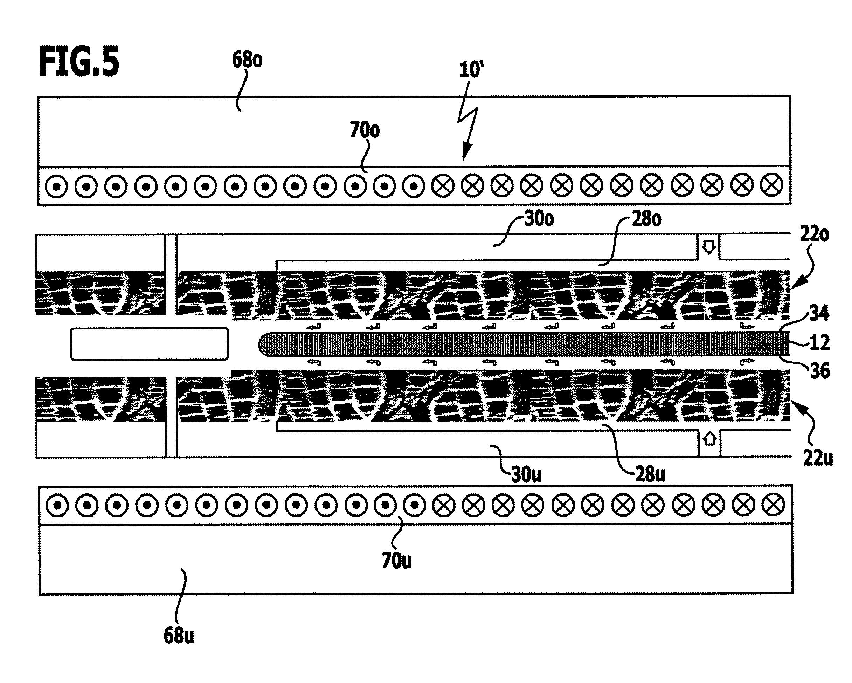

Bei einem dritten Ausführungsbeispiel einer erfindungsgemäßen Anlage 10', dargestellt in Fig. 5, sind diejenigen Elemente, die mit den voranstehenden Ausführungsbeispielen identisch sind, mit denselben Bezugszeichen versehen, so dass hinsichtlich der Beschreibung vollinhaltlich auf die Ausführungen hierzu verwiesen werden kann.

Im Gegensatz zu den voranstehend beschriebenen Ausführungsbeispielen ist bei dem dritten Ausführungsbeispiel als Heizeinrichtungen 50' ein Induktor 68 vorgesehen, dessen Induktorspulen 70o und 70u auf einer dem Substrat 12 abgewandten Seite der Aufheizblöcke 22o bzw. 22u und im Abstand von diesen angeordnet sind.

Die Induktorspulen 70o und 70u des Induktors erzeugen ein magnetisches Wechselfeld, welches dazu führt, dass in den Schutzschichten 48 aus Siliziumcarbid der Aufheizblöcke 22 Wirbelströme entstehen, die zu einer Aufheizung der Aufheizblöcke 22 führen.

Damit besteht in einfacher Weise die Möglichkeit, die Aufheizblöcke 22 mechanisch berührungsfrei durch das elektromagnetische Wechselfeld der Induktorspulen 70o und 70u auf die gewünschte Temperatur aufzuheizen und auf dieser zu halten.

Da die Aufheizblöcke 22 aufgrund ihrer großen Wärmekapazität lediglich insoweit nachgeheizt werden müssen, als Wärmeverluste entstehen, stellen die Induktorspulen 70o und 70u eine einfache Möglichkeit zur geregelten Heizung der Aufheizblöcke 22 dar.

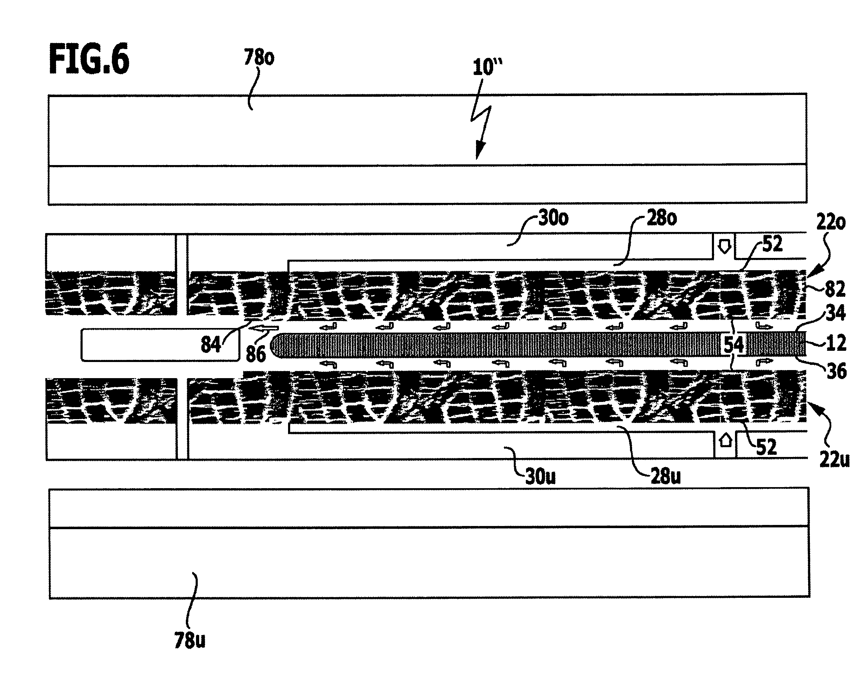

Bei einem vierten Ausführungsbeispiel, dargestellt in Fig. 6, ist anstelle der Induktorspulen 70o und 70u ein Mikrowellengenerator 78o und 78u vorgesehen, welcher Mikrowellen erzeugt, die von dem jeweils zugeordneten Aufheizblock 22o bzw. 22u absorbiert werden und dadurch, dass zumindest die Schutzschicht 48 aus Keramik, insbesondere Siliziumcarbid, ist, zu einer Aufheizung des gesamten jeweiligen Aufheizblocks 22o bzw. 22u führt.

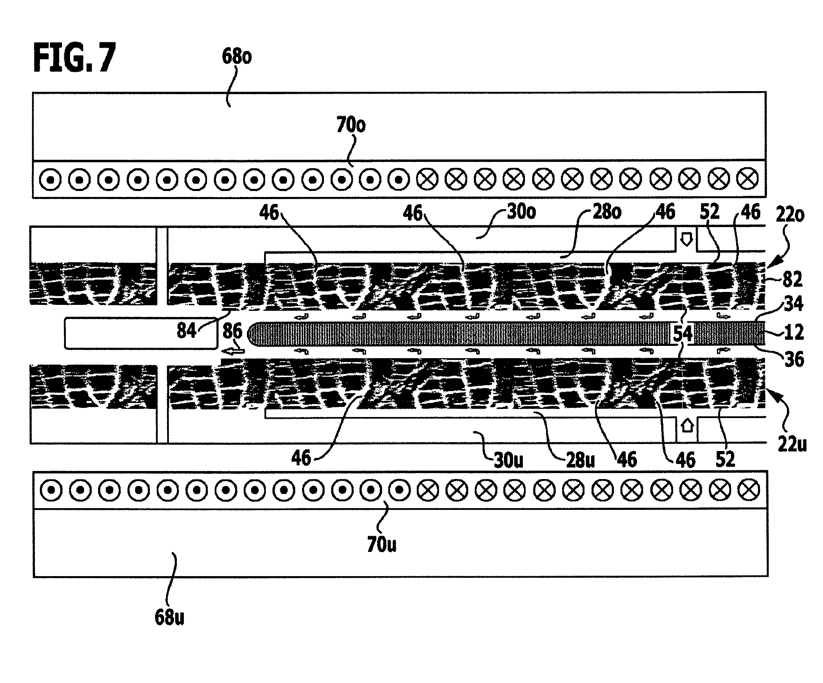

Bei einem fünften Ausführungsbeispiel, dargestellt in Fig. 7, sind die Aufheizblöcke 22o und 22u mit hinsichtlich ihrer Durchlassquerschnitte variierenden Poren und/oder Rissen 46 versehen, wobei der durch die Poren und/oder Risse 46 sich ergebende Durchlassquerschnitt in einem Zentralbereich 82 des jeweiligen Aufheizblocks 22 größer ist als in einem Außenbereich 84.

Insbesondere ist der Durchlassquerschnitt der Poren und/oder Risse 46 im Zentralbereich 82 mindestens um einen Faktor 2, vorzugsweise um einen Faktor von näherungsweise 3 größer als der Durchlassquerschnitt der Poren und/oder Risse 46 im Außenbereich 84, so dass die Strömungsgeschwindigkeit in den Gasströmen 26o und 26u in radialer Richtung 86 zum Zentralbereich 82 näherungsweise konstant sind, da sich in jeweils bezüglich des Zentralbereichs 82 radial außen liegenden Bereichen der durch die Poren und/oder Risse 46 hindurchtretende Gasstrom zu dem aus den radial weiter innen liegenden Poren und/oder Rissen 46 resultierenden Gasstrom addiert und folglich durch Reduktion der Durchlassquerschnitte der Poren und/oder Risse im Außenbereich 84 weniger Gas zugeführt wird, um die Strömungsgeschwindigkeiten des Gasstroms 26o und 26u über das gesamte Substrat hinweg im Wesentlichen konstant zu halten.

Dabei kann der Durchlassquerschnitt der Poren und/oder Risse in einer oder mehreren Stufen variieren. Besonders günstig ist es jedoch, wenn der Durchlassquerschnitt der Poren und Risse 46 zwischen dem Zentralbereich 82 und dem jeweiligen Außenbereich 84 im Wesentlichen kontinuierlich, vorzugsweise linear, abnimmt.

## Patentansprüche

1. Aufheizblock (22) für eine Anlage (10) zur thermischen Behandlung eines Substrats (12), insbesondere eines Halbleitersubstrats, wobei die Anlage (10) einen Substrataufnahmeraum (20) und auf mindestens einer Seite des Substrataufnahmeraums (20) den Aufheizblock (22) aufweist, mit welchem das Substrat (12) mechanisch berührungslos thermisch behandelbar ist,
**dadurch gekennzeichnet, dass** der Aufheizblock (22) als Faserverbundkörper (40) ausgebildet ist, dass der Faserverbundkörper (40) mit Durchlässen (46) für einen diesen von einer Flachseite (52) zur anderen Flachseite (54) durchsetzenden Gasstrom ausgebildet ist.

2. Aufheizblock nach Anspruch 1, **dadurch gekennzeichnet, dass** der Faserverbundkörper (40) im Bereich seiner wesentlichen, an den Gasstrom angrenzenden Oberflächen ein mit dem Gasstrom reaktionsunfähiges Material aufweist.

3. Aufheizblock nach Anspruch 1 oder 2, **dadurch gekennzeichnet, dass** der Faserverbundkörper (40) im Bereich der an den Gasstrom angrenzenden Oberflächen Keramikmaterial aufweist.

4. Aufheizblock nach Anspruch 3, **dadurch gekennzeichnet, dass** die an den Gasstrom angrenzenden Oberflächen die Oberflächen von Keramikschichten (48) des Faserverbundkörpers (40) sind.

5. Aufheizblock nach einem der voranstehenden Ansprüche, **dadurch gekennzeichnet, dass** die von den Durchlässen (46) gebildeten Durchlassquerschnitte zwischen einem Zentralbereich des Aufheizblocks und Außenbereichen des Aufheizblocks variieren.

6. Aufheizblock nach Anspruch 5, **dadurch gekennzeichnet, dass** die Durchlässe (46) in Außenbereichen des Aufheizblocks (22) einen kleinern Durchlassquerschnitt aufweisen als die Durchlässe (46) im Zentralbereich des Aufheizblocks (22).

7. Aufheizblock nach einem der voranstehenden Ansprüche, **dadurch gekennzeichnet, dass** die Durchlässe durch Poren und/oder Risse (46) des Faserverbundkörpers (40) gebildet sind.

8. Aufheizblock nach einem der voranstehenden Ansprüche, **dadurch gekennzeichnet, dass** die Fasern (42) in dem Faserverbundkörper (40) näherungsweise längs einer Vorzugsrichtung (60) verlaufen.

9. Aufheizblock nach Anspruch 8, **dadurch gekennzeichnet, dass** die Vorzugsrichtung (60) quer zu Flachseiten (52, 54) des Aufheizblocks (22) verläuft.

10. Anlage zur thermischen Behandlung von Substraten (12), insbesondere Halbleitersubstraten, umfassend einen Substrataufnahmeraum (20) und auf mindestens einer Seite des Substrataufnahmeraums (20) einen Aufheizblock (22) mit welchem das Substrat (12) im Substrataufnahmeraum (20) thermisch behandelbar ist, **dadurch gekennzeichnet, dass** der Aufheizblock (22) entsprechend einem oder mehreren der Ansprüche 1 bis 14 ausgebildet ist.

11. Anlage nach Anspruch 10, **dadurch gekennzeichnet, dass** der Aufheizblock (22) durch eine Heizeinrichtung (50) mechanisch berührungslos aufheizbar ist.

12. Anlage nach Anspruch 11, **dadurch gekennzeichnet, dass** der Aufheizblock (22) durch Heizstrahler aufheizbar ist.

13. Anlage nach Anspruch 11, **dadurch gekennzeichnet, dass** der Aufheizblock (22) mittels eines Induktors aufheizbar ist.

14. Anlage nach Anspruch 11, **dadurch gekennzeichnet, dass** der Aufheizblock (22) durch einen Mikrowellengenerator aufheizbar ist.

15. Anlage nach Anspruch 10, **dadurch gekennzeichnet, dass** der Aufheizblock (22) durch körperlichen thermischen Kontakt mit der Heizeinrichtung (50) aufheizbar ist.
